# EUROPÄISCHE PATENTSCHRIFT

(11) **EP 2 508 051 B1**
(45) Veröffentlichungstag und Bekanntmachung des Hinweises auf die Patenterteilung: **10.07.2013**
(21) Anmeldenummer: 10771332.3
(22) Anmeldetag: 12.10.2010
(51) Int. Cl.: H05K 7/20

(54) **KÜHLVORRICHTUNG**
COOLING DEVICE
DISPOSITIF DE REFROIDISSEMENT

(30) Priorität: 01.12.2009 DE 102009056483
(43) Veröffentlichungstag der Anmeldung: 10.10.2012
(73) Patentinhaber: Hydac Cooling GmbH, 66280 Sulzbach/Saar (DE)
(72) Erfinder: HERBER, Roland, 66132 Saarbrücken (DE); WETZSTEIN, Claudia, 66459 Kirkel (DE)
(74) Vertreter: Bartels, Martin Erich Arthur
(86) Internationale Anmeldenummer: PCT/EP2010/006230
(87) Internationale Veröffentlichungsnummer: WO 2011/066883

(56) Entgegenhaltungen:
- EP-A2- 0 454 123
- DE-A1- 2 135 677
- FR-A1- 2 705 523

## Beschreibung

Die Erfindung betrifft eine Kühlvorrichtung für eine elektrische Energieversorgung, mit zumindest einem ersten wärmeabgebenden Bauelement, dessen Leistungsbausteine mit der Kühlvorrichtung wärmeleitend verbunden sind, wobei eine fluidführende Verbindung flüssiges Kühlmittel von einer Pumpe über das erste wärmeabgebende Bauelement zu einem Kühler fördert, wobei zumindest zwischen dem ersten wärmeabgebenden Bauelement und dem Kühler und zwischen der Pumpe und dem ersten wärmeabgebenden Bauelement jeweils eine Absperreinrichtung in der fluidführenden Verbindung der Kühleinrichtung angeordnet ist.

Eine derartige Kühlvorrichtung ist aus DE 2 135 677 A bekannt geworden.

Die bekannte Kühlvorrichtung ist Teil einer Transformator-Gleichrichtervorrichtung, deren Gleichrichtereinheiten ölgekühlt sind. Die Gleichrichtereinheiten sind in separaten Gleichrichtergehäusen untergebracht, wobei das Kühlmittel bzw. Kühlöl mittels einer Pumpe durch eine Rohrleitung und dann parallel durch die Gleichrichtereinheiten gepumpt wird. Nach dem Durchlaufen und nach dem Kühlen der Gleichrichtereinheiten wird das erwärmte Kühlmittel bzw. Kühlöl in einen Kühler zurückgeführt, von wo aus das Kühlmittel bzw. Kühlöl wieder zur Pumpe gelangt. Nahe dem Einlaß und dem Auslaß eines jeden Gleichrichtergehäuses sind Ventile angeordnet, die ein Abtrennen der einzelnen Gehäuse von der Rohrleitung ermöglichen.

Im Bereich der Antriebstechnik und der elektrischen Energiegewinnung werden häufig zu kühlende Komponenten der Leistungselektronik eingesetzt. So ist es bekannt, Stromrichtermodule in der Antriebstechnik von Fahrzeugen, wie z.B. bei Straßenbahnen, Hybridbussen oder Oberleitungsbussen einzusetzen, die eine Umrichtung von Gleichspannung in Wechselspannung und umgekehrt vornehmen.

Bei Anlagen zur Gewinnung elektrischer Energie, etwa bei Windkraftanlagen, sind solche Umrichter in einem Gehäusemodul für elektrische Betriebsmittel angeordnet. Ein solches Gehäusemodul fasst alle Zuleitungen eines Generators bis zu einem Netzeinspeisepunkt zusammen. Ferner können in dem Gehäuse ein Transformator, ein Umrichter und eine Kühlvorrichtung als Baueinheit zusammengefasst sein. Solche Umrichter oder Stromrichter weisen eine Leistungsübertragung von einigen 1000 kW auf. Im Inneren eines Grundkörpers können dabei zumindest zwei Module angeordnet sein, die vorzugsweise schnell schaltende Leistungshalbleiter, beispielsweise IGBT's umfassen und als vorgefertigte Zweigpaarmodule, wie ein Zweigpaarventilsatz, ausgestaltet sein können. Die aufgrund von Umwandlungsverlusten entstehende Wärme wird an ein oder mehrere Kühlkörper abgegeben, die von Kühlflüssigkeit, häufig aus Korrosions- oder Frostschutzgründen als Wasser-Glykol-Gemisch ausgebildet, durchströmt oder umströmt sind. Im allgemeinen ist eine Kühlflüssigkeitstemperatur von weniger als 70 Grad Celsius für den Kühlmitteleintritt einzuhalten.

Sind zu Wartungsarbeiten an Bauteilen solcher Leistungselektronik Arbeiten durchzuführen, bedarf es unter Umständen der Entfernung großer Mengen an Kühlflüssigkeit aus der Kühlvorrichtung. Insbesondere bei beengten Raumverhältnissen in Anlagen, wie einer Gondel einer Windkraftanlage, ist es oft kaum möglich, geeignete Auffangbehälter für die Aufnahme der Kühlflüssigkeit überhaupt aufzustellen. Zudem ist die vollständige Entfernung der Kühlflüssigkeit aus solchen Anlagen zeitaufwendig.

Ausgehend von dem genannten Stand der Technik liegt daher der Erfindung die Aufgabe zugrunde, eine Kühlvorrichtung für zu kühlende Bauteile zu schaffen, die einen einfachen Austausch der zu kühlenden Bauteile ermöglicht.

Diese Aufgabe wird von einer Kühlvorrichtung mit den Merkmalen des Patentanspruches 1 in seiner Gesamtheit gelöst.

Gemäß dem kennzeichnenden Teil des Patentanspruches 1 ist zur Vermeidung eines Überdrucks in zumindest einem zu kühlenden Bauelement zumindest ein Druckbegrenzungsventil vorgesehen, das in Verbindung mit der Fluidführung innerhalb des Bauelement angeordnet ist und/oder als Teil einer Einrichtung zur Vorspannung der Kühlflüssigkeit in der fluidführenden Verbindung über die Druckseite eines stromab des Bauelements vorgesehenen Rückschlagventils mit dem Bauelement in Verbindung ist. Dadurch wird eine Beschädigung des Bauelements, wie eines Umrichters, ausgeschlossen, falls beim Betrieb der Vorrichtung versehentlich beide Hähne geschlossen werden sollten, wobei durch Temperaturanstieg innerhalb des Bauelements ein Überdruck und ein Bersten möglich wäre. In einer ersten Alternative ist ein Druckbegrenzungsventil in Verbindung mit der Fluidführung innerhalb des Bauelements vorgesehen; in einer zweiten Alternative wird ein gegebenenfalls im Bauelement aufgebauter Überdruck über die fluidführenden Verbindungen zur Saugseite der Pumpe hin abgebaut, deren Druckseite wiederum mit einem Druckbegrenzungsventil für die Einstellung des Systemdruckes in Verbindung ist.

Wenn stromauf und stromab der Kühlvorrichtung ein Absperren der fluidführenden Verbindung zum Zwecke der Entleerung des Kühlmittels ermöglicht ist, muss bei Wartungsarbeiten lediglich das relativ geringe Kühlmittelvolumen aus dem Bereich des zu wartenden Bauelementes abgelassen und aus der Kühlvorrichtung entfernt werden. Dadurch verringert sich sowohl der Zeitaufwand für diesen Ablassvorgang, als auch der Raumbedarf für etwaige Auffangbehälter von Kühlflüssigkeit. Ein Ventil in der fluidführenden Verbindung zwischen den beiden Absperreinrichtungen in der Kühlvorrichtung um das erste wärmeleitende Bauelement herum, ermöglicht das Ablassen von Kühlflüssigkeit vor einer Reparatur oder Wartung an dem wärmeabgebenden Bauelement der elektrischen Energieversorgung.

Bei einem besonders bevorzugten Ausführungsbeispiel ist für jedes weitere wärmeabgebende Bauelement der elektrischen Energieversorgung stromauf und stromab an dessen Einrichtung zur Kühlung und insbesondere an der dafür vorgesehenen fluidführenden Verbindung von Pumpe und Kühler, eine Absperreinrichtung mit der genannten Funktion und Wirkung vorgesehen. Es kann auch vorteilhaft sein stromauf und stromab eines Knotenpunktes in der fluidführenden Verbindung für Kühlmittel eine dahingehende Absperreinrichtung anzuordnen.

Die Absperreinrichtung kann ein beliebig gestaltetes Ventil mit möglicher Sperr-Schaltstellung, vorzugsweise in Sitzventilbauweise sein. Es kann vorteilhaft sein, ein einfach aufgebautes Sperrventil einzusetzen, beispielsweise in Form eines Hahns zur manuellen Betätigung. Die Schaltstellung des Hahns ist in einer kostengünstigen Bauart der Kühlvorrichtung optisch von außen erkennbar.

Eine automatische Absperrung der fluidführenden Verbindung vor und nach dem wärmeabgebenden Bauelement der Leistungselektronik einer elektrischen Energieversorgung ergibt sich in Anwendung eines Rückschlagventils oder eines entsperrbaren Rückschlagventils. Dieses ist in Strömungsrichtung des Kühlmittelstromes stromab weg von dem wärmeabgebenden Bauelement und stromauf hin zu dem wärmeabgebenden Bauelement bei einem Kühlmitteldruck, der geringfügig über dem Atmosphärendruck liegt, geöffnet. Ist die Pumpe für Kühlmittel während einer Wartungsphase der elektrischen Energieversorgung abgeschaltet und stellt sich eine Druckabsenkung in der fluidführenden Verbindung auf einen Grenzdruck ein, so schließt das Rückschlagventil stromauf und stromab des wärmeabgebenden Bauelementes automatisch.

Eine Druckabsenkung in der Kühlvorrichtung nach einem Ausschalten der Pumpe kann beispielsweise dadurch bewirkt werden, dass an einem Ausgleichsgefäß für die Kühlvorrichtung Kühlmittel abgelassen wird.

Bei einer besonders bevorzugten Ausführungsform der erfindungsgemäßen Kühlvorrichtung sind alle wärmeabgebenden Bauelemente der Hochdruckseite der Pumpe nachgelagert. Auf diese Weise lassen sich vor und nach jedem wärmeabgebenden Bauelement Absperreinrichtungen in die fluidführende Verbindung für Kühlmittel für die Bauelemente einfügen und bei einer etwaigen Wartung oder Reparatur jedes wärmeabgebenden Bauelements für sich aus dem Kühlmittelkreis auskoppeln, so dass nur das Kühlmittelvolumen des betreffenden Systemteiles abgelassen werden muss. Dies erleichtert den Wiederanlauf der Anlage und beugt der Gefahr vor, Luft-oder Gasblaseneinlagerungen in die Kühlflüssigkeit einzutragen, was ansonsten zum "Schlagen" der Pumpe und/oder zu Kavitationserscheinungen bei einem Wiederanlauf führen könnte.

Bei einem Ausführungsbeispiel der Kühlvorrichtung befindet sich mindestens ein wärmeabgebendes Bauelement in einem Umrichter, das vorzugsweise an einem Kühlkörper gelagert ist. Bei einem elektrischen Umrichter wird bekanntermaßen elektrische Energie in einer 3-phasigen Dioden-Brückenschaltung in Gleichstrom umgewandelt. Danach wird ein Kondensator als Glättungselement zum Glätten des Gleichstroms verwendet. Anschließend wird durch eine Frequenzumwandlung in einer Inverterschaltung mit einem Transistormodul und einem IGBT-Modul der elektrische Strom rücktransformiert.

In dem elektrischen Umrichter entsteht in der Diodenbrücke, im Transistormodul und im IGBT-Modul, sowie in den Rückwandlungselementen ein Umwandlungsverlust, wobei Wärme erzeugt wird. Die entstehende Wärme wird an einen Kühlkörper abgeführt. Um einen etwa konstanten Betriebsdruck zu erhalten, ist vorzugsweise in der Kühlvorrichtung eine Einrichtung zur Vorspannung der Kühlflüssigkeit oder des flüssigen Kühlmittels vorgesehen. Hierzu dient ein Druckspeicher, der als Membranspeicher, Kolben-oder Gasspeicher ausgebildet sein kann. Der Flüssigkeitsdruck in dem Druckspeicher wird durch ein Druckventil eingestellt und dergestalt begrenzt. Insbesondere in einer Windenergieanlage, deren Betriebsmittel und Maschinenraum auf einem Mast wenig Platz für Wartungspersonal, Werkzeug und Vorrichtungen oder Hilfsmittel bietet, eignet sich die erfindungsgemäße Kühlvorrichtung in besonderer Weise. Es sind bei der Wartung von Komponenten solcher Anlagen oft nur wenige Liter Kühlflüssigkeit abzulassen, nachdem die Absperreinrichtungen vor und nach der entsprechenden Komponente oder dem wärmeabgebenden Bauelement geschlossen wurden.

Nachstehend ist die Erfindung anhand der Zeichnung im Einzelnen erläutert. Es zeigen:
- Fig. 1: einen schematischen Schaltplan eines ersten Ausführungsbeispiels der erfindungsgemäßen Kühlvorrichtung, und
- Fig. 2: einen Schaltplan eines weiteren Ausführungsbeispiels der erfindungsgemäßen Kühlvorrichtung.

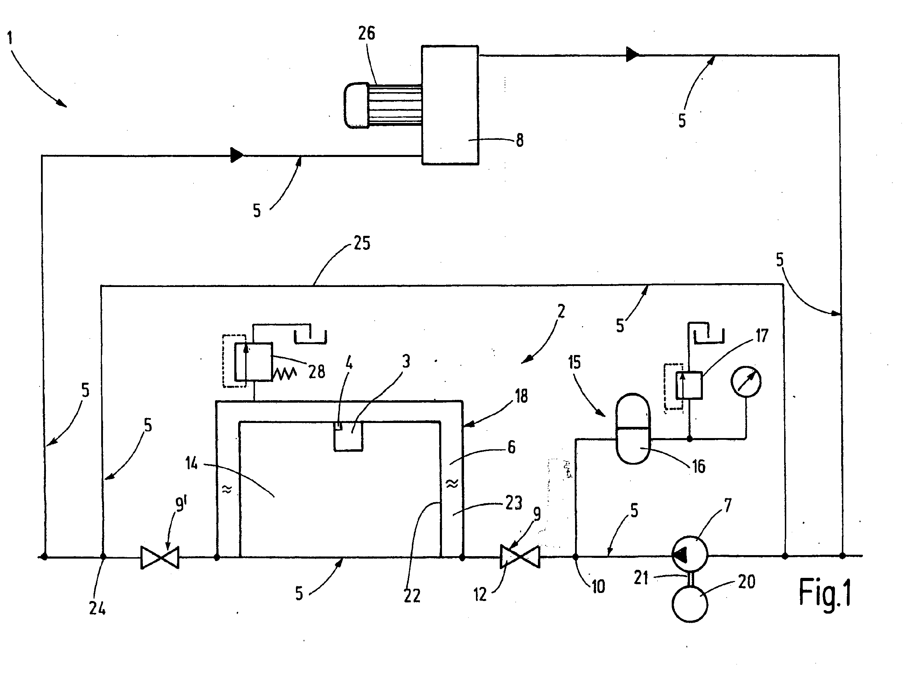

In Fig. 1 ist in einem schematischen Schaltplan eine Kühlvorrichtung 1 für eine elektrische Energieversorgung 2 einer Windkraftanlage schematisch mit ihren wesentlichen Komponenten gezeigt. Die Kühlvorrichtung 1 dient zur Kühlung von Leistungsbausteinen 4, wie einem Kondensatormodul mit Filter- und Beschaltungskondensator und einem Halbleitermodul eines Umrichters 14. Der Umrichter 14 weist ein Gehäuse 18 mit Kühlplatten auf, an denen Verlust behaftete, wärmeabgebende Bauelemente 3 angebracht sind. Die Kühlplatten sind von flüssigem Kühlmittel 6, das bevorzugt als Wasser-Glykol-Gemisch ausgebildet ist, durchspült. Die Betriebstemperatur der wärmeabgebenden Bauelemente 3 im Umrichter 14 wird dadurch auf Temperaturen gehalten, bei denen eine Selbstzerstörung der Halbleiterelemente vermieden ist.

Die Kühlvorrichtung 1 weist fluidführende Verbindungen 5 von einer Pumpe 7 zu einem Kühler 8 in Form von Rohren oder Schläuchen auf. Die Pumpe 7 ist vorzugsweise als Kreiselpumpe ausgebildet und von einem Elektromotor 20 über eine Antriebswelle 21 angetrieben. Die Pumpe 7 ist ferner vorrangig auf einen entsprechend großen Volumenstrom ausgelegt. Der Betriebsdruck der Kühlvorrichtung 1 soll beispielsweise etwa 4 Bar betragen. In der fluidführenden Verbindung 5 stromauf der Pumpe 7 ist an einem Knotenpunkt 10 eine Verbindung zu einem Druckspeicher 16 vorgesehen, der eine Einrichtung 15 zum Vorspannen des Kühlmittels 6 in dem gesamten Leitungsnetz und zur Vorspannung für die angeschlossenen Kühlplatten bildet. Zur Einstellung des Druckspeicher-Druckes ist ein Druckventil 17 vorgesehen.

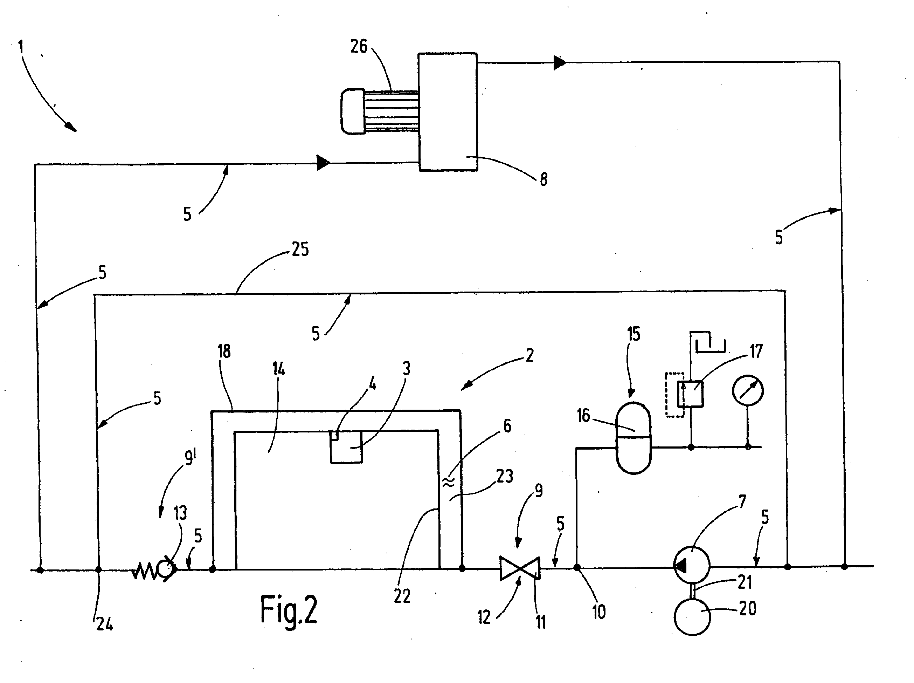

Stromauf des Knotenpunktes 10 ist eine Absperreinrichtung 9 angeordnet. Die Absperreinrichtung 9 ist als Hahn 12 ausgebildet. Der Hahn 12 ist manuell betätigbar und vorzugsweise als Kugelhahn ausgebildet. Stromauf des Hahnes 12 ist der Umrichter 14 mit Kühlplatten angeordnet, wodurch ermöglicht ist, dass Wärme der Bauelemente 3 an das die Kühlplatten durchströmende Kühlmedium abgegeben werden kann. Stromauf des Gehäuses 18 des Umrichters 14 ist die fluidführende Verbindung 5 weiter geführt und weist eine zweite Absperreinrichtung 9' auf. In der Fig. 1 ist die zweite Absperreinrichtung 9' als manuell betätigbarer Kugelhahn dargestellt. In dem in Fig. 2 gezeigten Ausführungsbeispiels ist anstelle des Kugelhahns ein Sperrventil vorgesehen, das als Rückschlagventil 13 ausgebildet ist. Das Rückschlagventil 13 sperrt gegen eine Strömung in Richtung auf den Umrichter 14 hin, ist jedoch für eine Strömung aus dem Umrichter 14 heraus druckbetätigt öffenbar.

Die Absperreinrichtungen 9, 9' ermöglichen ein Entkoppeln des Umrichters 14 vom restlichen Kühlsystem. Ein Ablassen von Kühlmittel 6 aus den Kühlplatten des Umrichters 14 ist dadurch, wie vorstehend beschrieben, auf einfach Weise ermöglicht, um insbesondere dergestalt die Baukomponenten des Umrichters 14 zu Wartungszwecken freizulegen.

Stromauf der zweiten Absperreinrichtung 9' ist ein Knotenpunkt 24 einer Bypassleitung 25 angebracht, der einen Kühlmittelstrom an einem Kühler 8 vorbei zurück zu der Pumpe 7 ermöglicht. Der Kühler 8, über den der Kühlmittelkreislauf normalerweise zurück zur Pumpe 7 erfolgt, weist ein von einem Motor 26 angetriebenes Kühlgebläse auf und ist derart dimensionierbar, dass er das Kühlmittel auf eine Temperatur rückkühlt, die geeignet ist, genügen Wärmespeicherkapazität des Kühlmittels für die wärmeabgebenden Bauelemente 3 zur Verfügung zu stellen.

Die Fig. 1 und 2 zeigen lediglich ein Anwendungsbeispiel der Kühlvorrichtung, insbesondere die Einbindung eines wärmeabgebenden Bauelementes 3 zwischen den Absperreinrichtung 9, 9'. In gleicher Weise lassen sich in der Art einer Reihenschaltung weitere wärmeabgebende Bauelemente

(nicht dargestellt) zwischen den genannten Absperreinrichtungen 9, 9' einbinden.

Wie ausgeführt, sind bei dem Beispiel von Fig. 1 die Absperreinrichtungen, 9,9' stromauf und stromab des Umrichters 14 als Sperrventile, etwa Kugelhähne 12, ausgebildet. Um eine Beschädigung des Umrichters 14 auszuschließen, falls beim Betrieb der Vorrichtung versehentlich beide Hähne geschlossen werden sollten, wobei durch Temperaturanstieg innerhalb des Umrichters 14 ein Überdruck und ein Bersten möglich wäre, ist bei dem Beispiel von Fig. 1 ein Druckbegrenzungsventil 28 in Verbindung mit der Fluidführung innerhalb des Umrichters 14 vorgesehen. Wie ersichtlich, ist bei dem Ausführungsbeispiel von Fig. 2 am Umrichter 14 kein Druckbegrenzungsventil vorgesehen, weil die stromab des Umrichters 14 vorgesehene Absperreinrichtung 9' durch ein Rückschlagventil 13 gebildet ist, über das ein gegebenenfalls im Umrichter 14 aufgebauter Überdruck über die fluidführenden Verbindungen 5, einschließlich der Bypassleitung 25, zur Saugseite der Pumpe 7 hin abgebaut wird, deren Druckseite wiederum über den Knotenpunkt 10 mit dem Druckbegrenzungsventil 17 für die Einstellung des Systemdruckes in Verbindung ist.

## Patentansprüche

1. Kühlvorrichtung für eine elektrische Energieversorgung (2), mit zumindest einem ersten wärmeabgebenden Bauelement (3), dessen Leistungsbausteine (4) mit der Kühlvorrichtung (1) wärmeleitend verbunden sind, wobei eine fluidführende Verbindung (5) flüssiges Kühlmittel (6) von einer Pumpe (7) über das erste wärmeabgebende Bauelement (3) zu einem Kühler (8) führt, wobei zumindest zwischen dem ersten wärmeabgebenden Bauelement (3) und dem Kühler (8) und zwischen der Pumpe (7) und dem ersten wärmeabgebenden Bauelement (3) jeweils eine Absperreinrichtung (9', 9) in der fluidführenden Verbindung (5) angeordnet ist, **dadurch gekennzeichnet, dass** zur Vermeidung eines Überdrucks in zumindest einem zu kühlenden Bauelement (3, 14) zumindest ein Druckbegrenzungsventil (17, 28) vorgesehen ist, das in Verbindung mit der Fluidführung innerhalb des Bauelements (3, 14) angeordnet ist und/oder als Teil einer Einrichtung (15) zur Vorspannung der Kühlflüssigkeit (6) in der fluidführenden Verbindung (5) über die Druckseite eines stromab des Bauelements (3, 14) vorgesehenen Rückschlagventils (13) mit dem Bauelement (3, 14) in Verbindung ist.

2. Kühlvorrichtung nach Anspruch 1, **dadurch gekennzeichnet, dass** jeweils eine Absperreinrichtung (9, 9') stromauf und stromab eines jeden wärmeabgebenden Bauelements (3) der elektrischen Energieversorgung (2) zwischen dem wärmeabgebenden Bauelement (3) und einem in diesem vor- und nachgelagerten Bauelement oder einem Knotenpunkt (10) in der fluidführenden Verbindung (5) angeordnet ist.

3. Kühlvorrichtung nach Anspruch 1 oder 2, **dadurch gekennzeichnet,**
**dass** zumindest eine Absperreinrichtung (9) aus einem Sperrventil gebildet ist.

4. Kühlvorrichtung nach einem der Ansprüche 1 bis 3, **dadurch gekennzeichnet, dass** zumindest eine Absperreinrichtung (9) als betätigbarer Hahn (12) ausgebildet ist.

5. Kühlvorrichtung nach einem der Ansprüche 1 bis 4, **dadurch gekennzeichnet, dass** zumindest eine Absperreinrichtung (9) als Kugelhahn ausgebildet ist.

6. Kühlvorrichtung nach einem der Ansprüche 2 bis 5, **dadurch gekennzeichnet, dass** das Sperrventil ein Rückschlagventil (13) oder ein entsperrbares Rückschlagventil ist, das in Strömungsrichtung des Kühlflüssigkeitsstromes gesehen weg von dem wärmeabgebenden Bauelement (3) bei Betriebsdruck der Kühlvorrichtung (1) öffnet.

7. Kühlvorrichtung nach einem der Ansprüche 1 bis 6, **dadurch gekennzeichnet, dass** alle von der Kühlvorrichtung (1) versorgten wärmeabgebenden Bauelemente (3) stromab der Pumpe (7) angeordnet sind.

8. Kühlvorrichtung nach einem der Ansprüche 1 bis 7, **dadurch gekennzeichnet, dass** zumindest das erste wärmeabgebende Bauelement (3) ein Bauteil eines Stromrichters oder Umrichters (14) ist.

9. Kühlvorrichtung nach einem der Ansprüche 1 bis 8, **dadurch gekennzeichnet, dass** die Kühlflüssigkeit (6) ein Wasser-Glykol-Gemisch ist.

10. Kühlvorrichtung nach einem der Ansprüche 1 bis 9, **dadurch gekennzeichnet, dass** die Kühlvorrichtung (1) eine Einrichtung (15) zur Vorspannung der Kühlflüssigkeit (6) in der fluidführenden Verbindung (5) aufweist.

11. Kühlvorrichtung nach Anspruch 10, **dadurch gekennzeichnet, dass** die Einrichtung (15) zur Vorspannung der Kühlflüssigkeit (6) ein Druckspeicher (16) umfasst.

12. Kühlvorrichtung nach Anspruch 11, **dadurch gekennzeichnet, dass** der Kühlflüssigkeitsdruck in dem System von zumindest einem Druckventil (17) begrenzt ist.

13. Kühlvorrichtung nach einem der Ansprüche 1 bis 12, **dadurch gekennzeichnet, dass** die Kühlvorrichtung (1) Teil einer Windenergieanlage ist.

14. Kühlvorrichtung nach Anspruch 13, **dadurch gekennzeichnet, dass** die Kühlvorrichtung (1) in einem Gehäusemodul der Windenergieanlage untergebracht ist.

## Claims

1. A cooling device for an electric power supply (2) comprising at least one first heat-dissipating component (3) the power modules (4) of which are connected to the cooling device (1) in a thermally conductive manner, a fluid-carrying connection (5) conveying liquid coolant (6) from a pump (7) via the first heat-dissipating component (3) to a cooler (8), there being one shut-off device (9', 9) respectively in the fluid-carrying connection (5) at least between the first heat-dissipating component (3) and the cooler (8) and between the pump (7) and the first heat-dissipating component (3), **characterised in that** to prevent an overpressure in at least one component (3, 14) which is to be cooled, there is at least one pressure limiting valve (17, 28) which, in connection with the fluid duct, is located within the component (3, 14) and/or which, as part of a device (15) for preloading the cooling liquid (6) in the fluid-carrying connection (5), is connected to the component (3, 14) via the pressure side of a check valve (13) provided downstream of the component (3, 14).

2. The cooling device according to Claim 1, **characterised in that** there is one shut-off device (9, 9') respectively upstream and downstream of each heat-dissipating component (3) of the electric power supply (2) between the heat-dissipating component (3) and a component located upstream and downstream in the latter or a node point (10) in the fluid-carrying connection (5).

3. The cooling device according to Claim 1 or 2, **characterised in that** at least one shut-off device (9) is formed from a shut-off valve.

4. The cooling device according to any of Claims 1 to 3, **characterised in that** at least one shut-off device (9) is in the form of an actuatable cock (12).

5. The cooling device according to any of Claims 1 to 4, **characterised in that** at least one shut-off device (9) is in the form of a ball valve.

6. The cooling device according to any of Claims 2 to 5, **characterised in that** the shut-off valve is a check valve (13) or an unlockable check valve which, as viewed in the flow direction of the coolant flow, opens away from the heat-dissipating component (3) at the operating pressure of the cooling device (1).

7. The cooling device according to any of Claims 1 to 6, **characterised in that** all of the heat-dissipating components (3) supplied by the cooling device (1) are located downstream of the pump (7).

8. The cooling device according to any of Claims 1 to 7, **characterised in that** at least the first heat-dissipating component (3) is a part of a converter (14).

9. The cooling device according to any of Claims 1 to 8, **characterised in that** the cooling liquid (6) is a water/glycol mixture.

10. The cooling device according to any of Claims 1 to 9, **characterised in that** the cooling device (1) has a device (15) for preloading the cooling liquid (6) in the fluid-carrying connection (5).

11. The cooling device according to Claim 10, **characterised in that** the device (15) for preloading the cooling liquid (6) comprises a pressure accumulator (16).

12. The cooling device according to Claim 11, **characterised in that** the cooling liquid pressure in the system is limited by at least one pressure valve (17).

13. The cooling device according to any of Claims 1 to 12, **characterised in that** the cooling device (1) is part of a wind turbine.

14. The cooling device according to Claim 13, **characterised in that** the cooling device (1) is accommodated in a housing module of the wind turbine.

## Revendications

1. Dispositif de refroidissement d'une alimentation (2) en énergie électrique, comprenant au moins un premier élément (3) qui cède de la chaleur et dont les modules (4) de puissance sont reliés d'une manière conductrice de la chaleur au dispositif (1) de refroidissement, une liaison (5) fluidique conduisant du fluide (6) de refroidissement liquide d'une pompe à un dissipateur (8) de chaleur par l'intermédiaire du premier élément (3) qui cède de la chaleur, respectivement un dispositif (9', 9) d'arrêt étant monté dans la liaison (5) fluidique au moins entre le premier élément (3) qui cède de la chaleur et le dissipateur (8) de chaleur et entre la pompe (7) et le premier élément (3) qui cède de la chaleur, **caractérisé en ce que**, pour empêcher une surpression dans au moins un élément (3, 14) à refroidir, il est prévu au moins une soupape (17, 28) de limitation de la pression, qui est en liaison avec la conduite de fluide au sein de l'élément (3, 14) et/ou, en tant que partie d'un dispositif (15) dé précompression du liquide (6) de refroidissement dans la liaison (5) fluidique, est en liaison avec l'élément (3, 14) par le côté sous pression d'un clapet (13) antiretour prévu en aval de l'élément (3, 14).

2. Dispositif de refroidissement suivant la revendication 1, **caractérisé en ce que** respectivement un dispositif (9, 9') d'arrêt est monté dans la liaison (5) fluidique en amont et en aval de chaque élément (3) qui cède de la chaleur de l'alimentation (2) en énergie électrique entre l'élément (3) qui cède de la chaleur et un élément ou un noeud (10) en amont et en aval de celui-ci.

3. Dispositif de refroidissement suivant la revendication 1 ou 2, **caractérisé en ce qu'**au moins un dispositif (6) d'arrêt est formé d'une vanne d'arrêt.

4. Dispositif de refroidissement suivant l'une des revendications 1 à 3, **caractérisé en ce qu'**au moins un dispositif (9) d'arrêt est constitué sous la forme d'un robinet (12) qui peut être actionné.

5. Dispositif de refroidissement suivant l'une des revendications 1 à 4, **caractérisé en ce qu'**au moins un dispositif (9) d'arrêt est constitué sous la forme d'un robinet à boisseau sphérique.

6. Dispositif de refroidissement suivant l'une des revendications 2 à 5, **caractérisé en ce que** la vanne d'arrêt est un clapet (13) antiretour ou un clapet antiretour qui peut être ouvert et qui, à la pression de fonctionnement du dispositif (1) de refroidissement, s'ouvre, considéré dans la direction d'écoulement du courant de liquide de refroidissement, en s'éloignant de l'élément (3) qui cède de la chaleur.

7. Dispositif de refroidissement suivant l'une des revendications 1 à 6, **caractérisé en ce que** tous les éléments (3), qui sont alimentés par le dispositif (1) de refroidissement et qui cèdent de la chaleur, sont montés en
aval de la pompe (7).

8. Dispositif de refroidissement suivant l'une des revendications 1 à 7, **caractérisé en ce qu'**au moins le premier élément (3) qui cède de la chaleur est un composant d'un convertisseur ou d'un changeur (14) de fréquence.

9. Dispositif de refroidissement suivant l'une des revendications 1 à 8, **caractérisé en ce que** le liquide (6) de refroidissement est un mélange d'eau et de glycol.

10. Dispositif de refroidissement suivant l'une des revendications 1 à 9, **caractérisé en ce que** le dispositif (1) de refroidissement comporte un dispositif (15) de compression préalable du liquide (6) de refroidissement dans la liaison (5) fluidique.

11. Dispositif de refroidissement suivant la revendication 10, **caractérisé en ce que** le dispositif (15) de compression du liquide (6) de refroidissement comprend un accumulateur (16) de pression.

12. Dispositif de refroidissement suivant la revendication 11, **caractérisé en ce que** la pression du liquide de refroidissement dans le système est limitée par au moins une soupape (17) de refoulement.

13. Dispositif de refroidissement suivant l'une des revendications 1 à 12, **caractérisé en ce que** le dispositif (1) de refroidissement fait partie d'une éolienne.

14. Dispositif de refroidissement suivant la revendication 13, **caractérisé en ce que** le dispositif (1) de refroidissement est logé dans un module d'enveloppe de l'éolienne.
